# EUROPÄISCHE PATENTSCHRIFT

(11) **EP 1 037 273 B1**
(45) Veröffentlichungstag und Bekanntmachung des Hinweises auf die Patenterteilung: **19.09.2007**
(21) Anmeldenummer: 00104265.4
(22) Anmeldetag: 01.03.2000
(51) Int. Cl.: H01L 21/761, H01L 27/02

(54) **Leseverstärkeranordnung mit Feldeffekttransistor mit kurzer Kanallänge und einstellbarer Einsatzspannung**
Sense amplifier comprising field effect transistor with short channel length and adjustable threshold voltage
Amplificateur de lecture comprenant un transistor à effet de champ à canal court et à tension de seuil ajustable

(30) Priorität: 15.03.1999 DE 19911463
(43) Veröffentlichungstag der Anmeldung: 20.09.2000
(73) Patentinhaber: Infineon Technologies AG, 81669 München (DE)
(72) Erfinder: Schneider, Helmut, 80993 München (DE); Lindolf, Jürgen, Dr., 86316 Friedberg (DE); Borst, Thomas, 85579 Neubiberg (DE); Ruckerbauer, Hermann, 94554 Moos (DE)
(74) Vertreter: Müller - Hoffmann & Partner

(56) Entgegenhaltungen:
- WO-A-98/59419
- US-A- 5 838 047
- PATENT ABSTRACTS OF JAPAN Bd. 1999, Nr. 01, 29. Januar 1999 (1999-01-29) & JP 10 275466 A (MITSUBISHI ELECTRIC CORP), 13. Oktober 1998 (1998-10-13) -& US 5 900 665 A (TOBITA YOUICHI) 4. Mai 1999 (1999-05-04)
- PATENT ABSTRACTS OF JAPAN Bd. 1999, Nr. 03, 31. März 1999 (1999-03-31) & JP 10 340998 A (TOSHIBA CORP), 22. Dezember 1998 (1998-12-22) -& US 6 040 610 A (NOGUCHI MITSUHIRO ET AL) 21. März 2000 (2000-03-21)

## Beschreibung

Die vorliegende Erfindung bezieht sich auf eine Leseverstärkeranordnung mit einem in einem Halbleitersubstrat vorgesehenen Feldeffekttransistor mit kurzer Kanallänge und einstellbarer Einsatzspannung, bei der der Feldeffekttransistor in einer im Halbleitersubstrat isolierten Wanne vorgesehen ist, die einen Anschluss aufweist, an dem ein variables Wannenpotential anliegt.

Mit der zunehmenden Integrationsdichte in integrierten Schaltungen ist zwangsläufig eine Reduzierung der Abmessungen von Transistoren verbunden. Diese Reduzierung der Abmessungen von Transistoren führt, wenn diese Feldeffekttransistoren sind, zu immer geringeren Kanallängen. Feldeffekttransistoren mit reduzierten Kanallängen werden auch als Kurzkanaltransistoren bezeichnet.

Solche Kurzkanaltransistoren zeigen im Betrieb aber einen nicht unerheblichen Nachteil: sie weisen ein ausgeprägtes sogenanntes "Roll-Off"-Verhalten auf. Darunter wird ein mehr oder weniger starkes Absinken der Einsatzspannung mit abnehmender Kanal- bzw. Gatelänge verstanden. Schon relativ geringfügige Schwankungen der Gatelänge, welche beispielsweise auf veränderte Masken-Vorspannungen zurückzuführen sind, bedingen dann eine vergleichsweise große Änderung der Einsatzspannung.

Mit anderen Worten, je weiter die Kanal- bzw. Gatelänge von Feldeffekttransistoren reduziert wird, desto stärker wirken sich geringfügige Schwankungen dieser Kanal- bzw. Gatelänge auf die Einsatzspannung aus. Dies bedeutet, daß angestrebte Werte für die Einsatzspannung nur sehr schwer genau eingehalten werden können, wenn die Kanal- bzw. Gatelänge der Feldeffekttransistoren weiter reduziert wird.

Bei Leseverstärkern bzw. Sense Amplifiers ist das "Roll-Off"-Verhalten der Kurzkanaltransistoren von besonderem Nachteil: die Lese- bzw. Sense-Geschwindigkeit von diesen hängt nämlich empfindlich von der Spannungsdifferenz zwischen einem zu lesenden Signal und der Einsatzspannung des entsprechenden Feldeffekttransistors des Leseverstärkers ab, was auch als "Overdrive" bezeichnet wird.

Um ein ausgeprägtes "Roll-Off"·Verhalten zu verhindern und einen Leseverstärker mit genügend "Overdrive" zu realisieren, wurde dieser bisher im Design so ausgelegt, daß eine ausreichende Spanne zur Aufnahme von Prozeßschwankungen gewährleistet ist.

Das Vorsehen einer derartigen Spanne steht aber dem allgemein angestrebten Ziel einer Miniaturisierung grundsätzlich entgegen.

Im einzelnen ist aus WO 98/59419 eine Schaltungsanordnung bekannt. bei der der Spannungspegel eines an eine Wanne anzulegenden Potenzials durch eine Steuerschaltung gesteuert ist. Ein Signal Vbbn ist an Bulk eines Transistors angelegt, und einem Vergleicher sind ein Signal f (Vt) sowie ein Ausgangssignal eines Bezugssignalgenerators zugespeist. Der Vergleicher steuert einen Feldeffekttransistor an, der wiederum in Reihe mit weiteren Transistoren liegt, welche ihrerseits das Signal Vbbn liefern. Es wird hier also das Wannenpotenzial allenfalls abhängig von der Differenz zwischen einem Bezugssignal und dem von der Schwellenspannung Vt abhängigen Signal f (Vt) gesteuert. Eine ähnliche Schaltungsanordnung ist noch in der JP 10 275 466 A beziehungsweise der US5900665 A beschrieben.

Es ist Aufgabe der vorliegenden Erfindung, eine Leseverstärkeranordnung zu schaffen, die auch bei Einsatz von Kurzkanaltransistoren die Einstellung einer definierten Einsatzspannung erlaubt.

Diese Aufgabe wird bei einer Leseverstärkeranordnung mit einem in einem Halbleitersubstrat vorgesehenen Feldeffekttransistor mit kurzer Kanallänge und einstellbarer Einsatzspannung erfindungsgemäß dadurch gelöst, daß das Wannenpotential abhängig von der Differenz zwischen der tatsächlichen Einsatzspannung des Feldeffekttransistors und deren Zielwert steuerbar ist.

Es sind auch Anordnungen möglich, bei denen mehrere Transistoren eines Leseverstärkers in derselben Wanne liegen. Dies ist sogar eine der Hauptanwendungen der vorliegenden Erfindung.

Es werden also als Kurzkanaltransistoren ausgebildete Feldeffekttransistoren in je-weils voneinander isolierten Wannen vorgesehen, deren Potential variabel ist. Durch entsprechende Einstellung des Wannenpotentials können dann ohne weiteres Abweichungen der tatsächlichen Einsatzspannung von deren Zielwert mit Hilfe des Substratsteuereffektes ausgeglichen werden. Größer werdende negative Spannungswerte des Wannenpotentials lassen nämlich die Einsatzspannung eines Feldeffekttransistors bei gleicher Kanal- bzw. Gatelänge ansteigen, so daß es möglich ist, über das Wannenpotential mit Hilfe des Substratsteuereffektes die Einsatzspannung auf einen gewünschten Zielwert zu bringen. Damit besteht die Möglichkeit, die Lese- bzw. Sense-Geschwindigkeit des Leseverstärkers zu optimieren.

Die Einstellung des Wannenpotentials kann beispielsweise über eine Fuse vorgenommen werden, die dann eine bestimmte Spannung der Wanne zuführt, wenn die Abweichung zwischen der tatsächlichen Einsatzspannung und deren Zielwert eine bestimmte Schwelle überschreitet. Es ist aber auch möglich, das Wannenpotential in einem autoadaptiven Regelkreis so einzustellen, daß die Einsatzspannung des Feldeffekttransistors ihrem Zielwert entspricht.

Geeignete Werte für die Spannung zur Einstellung des Wannenpotentials können beispielsweise zwischen +200 mV bis -400 mV liegen, wobei die Einstellung in Schritten von 50 mV möglich sein kann. Aus Gründen der Stromersparnis kann es zweckmäßig sein, im abgeschalteten Zustand des Transistors ein Wannenpotential einzustellen, das von aktivem Potential verschieden ist. Dies kann zweckmäßigerweise 0 V sein.

Nachfolgend wird die Erfindung anhand der Zeichnungen näher erläutert. Es zeigen:
- Fig. 1: ein Kennliniendiagramm zur Erläuterung der Abhängigkeit der Einsatzspannung Vth (Volt) von der Abmessung bzw. Kanallänge L_{Design} (µm) mit dem Wannenpotential V_{BS} als Parameter,
- Fig. 2: ein Prinzipschaltbild zur Erläuterung der Erfindung,
- Fig. 3: ein weiteres Prinzipschaltbild zur Erläuterung der Erfindung und
- Fig. 4: einen Schnitt durch einen Feldeffekttransistor mit isolierter Wanne.

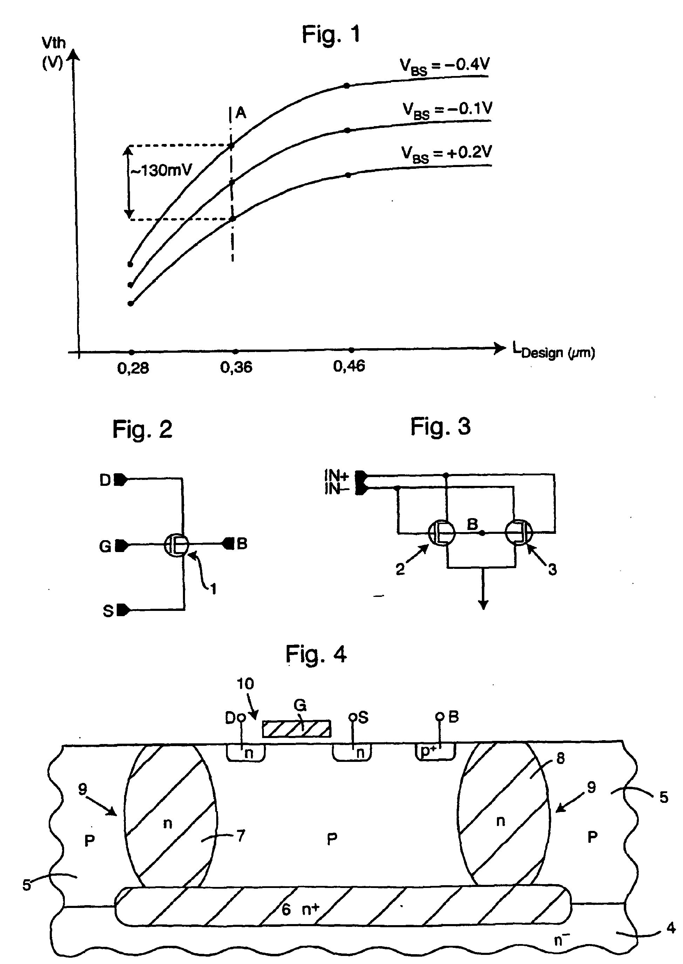

Fig. 1 zeigt die Abhängigkeit der Einsatzspannung Vth (in V) von der Abmessung bzw. Kanal- oder Gatelänge L_{Design} (µm) bei einem Feldeffekttransistor. Abhängig von dem Wannenpotential, das durch eine Bulk-(Halbleiterkörper-)Source-Spannung V_{BS} festgelegt ist, ergeben sich für die gleiche Abmessung L_{Design}, also beispielsweise 0,36 µm, verschiedene Werte für die Einsatzspannung Vth, so daß ein variabler Arbeitspunkt A vorliegt, der beispielsweise in einem Bereich von ungefähr 130 mv schwankt. Dabei wandert der Arbeitspunkt A mit stärker negativ werdender Spannung V_{BS} zu höheren Werten von Vth. Die Einsatzspannung wächst also mit zunehmend größeren negativen Spannungswerten des Wannenpotentials an.

Wie in Fig. 1 gezeigt ist, kann die Spannung V_{BS} beispielsweise variabel von +200 mV bis -400 mV in Schritten von z.B. 50 mV verändert werden, um eine solche Einsatzspannung Vth bei der gegebenen Abmessung L_{Design} zu erhalten, welche dem angestrebten Zielwert für die Einsatzspannung am nächsten kommt.

In bevorzugter Weise wird die Spannung V_{BS} = 0 V einem abgeschalteten Zustand des Feldeffekttransistors zugeordnet, um so zur Stromersparnis beizutragen.

Fig. 2 zeigt schematisch einen Feldeffekttransistor 1 mit Drain D, Gate G und Source S. Außerdem ist ein Anschluß B ("bulk") zum Anlegen des Wannenpotentials vorgesehen. Über diesen Anschluß B wird die Spannung V_{BS} der Wanne des Feldeffekttransistors 1 zugeführt, die zu der gewünschten Einsatzspannung Vth führt.

Fig. 3 zeigt ein Schaltbild mit zwei Feldeffekttransistoren 2, 3 mit gemeinsamer Wanne, wobei am Anschluß B ein variables Potential anliegt und die Feldeffekttransistoren 2, 3 an Eingängen IN+ und IN- liegen.

In Fig. 4 ist ein Schnitt durch einen Feldeffekttransistor mit isolierter Wanne gezeigt: auf einem N⁻-leitenden Halbleitersubstrat ist eine p-leitende epitaktische Schicht 5 angeordnet, wobei zwischen dem Halbleitersubstrat 4 und der epitaktischen Schicht 5 eine n⁺-leitende, vergrabene Schicht ("buried layer") vorgesehen ist. Diese vergrabene Schicht 6 bildet mit n-leitenden Diffusionsgebieten 7, 8 eine Wanne 9, welche einen innerhalb der Wanne 9 angeordneten Feldeffekttransistor 10 mit n-leitendem Drain D, n-leitendem Source S und Gate G aus polykristallinem Silizium von anderen Bauelementen isoliert. Über eine p⁺-leitende Zone mit einem Anschluß B wird dem Feldeffekttransistor ein Wannenpotential durch Aufprägen der Spannung V_{BS} so zugeführt, daß der Feldeffekttransistor die gewünschte Einsatzspannung Vth hat. Im abgeschalteten Zustand hat dieses Potential vorzugsweise den Wert 0 V.

Eine Struktur, wie diese in Fig. 4 gezeigt ist, kann beispielsweise durch Ionenimplantation hergestellt werden.

Das Wannenpotential, das über den Anschluß B zugeführt wird, kann dabei abhängig von der tatsächlichen Einsatzspannung und dem Zielwert der Einsatzspannung, also letztlich abhängig von der Differenz zwischen der tatsächlichen Einsatzspannung und deren Zielwert, gesteuert werden. Dabei ist auch eine Regelung möglich, indem "automatisch" das Wannenpotential, das am Anschluß B liegt, auf einen solchen Wert eingestellt wird, der die Einsatzspannung Vth zu ihrem Zielwert führt.

Gegebenenfalls können in der Wanne 9 auch mehrere Feldeffekttransistoren eines Leseverstärkers liegen.

## Patentansprüche

1. Leseverstärkeranordnung mit einem in einem Halbleitersubstrat vorgesehenen Feldeffekttransistor mit kurzer Kanallänge (L_{Design}) und einstellbarer Einsatzspannung (Vth), bei der der Feldeffekttransistor (10) in einer im Halbleitersubstrat (4, 5) isolierten Wanne (9) vorgesehen ist, die einen Anschluss (B) aufweist, an der ein variables Wannenpotential (V_{BS}) anliegt,
**dadurch gekennzeichnet, dass**
das Wannenpotential (V_{BS}) abhängig von der Differenz zwischen der tatsächlichen Einspatzspannung (Vth) des Feldeffekttransistors (10) und deren Zielwert steuerbar ist.

2. Leseverstärkeranordnung nach Anspruch 1,
**dadurch gekennzeichnet, dass**
die Einsatzspannung (Vth) des Feldeffekttransistors (10) mit größer werdenden negativen Spannungswerten des Wannenpotentials (VBS) anwächst.

3. Leseverstärkeranordnung nach Anspruch 1 oder 2,
**dadurch gekennzeichnet, dass**
das Wannenpotential zwischen +200 mV und -400 mV in Stufen von etwa 50 mV variabel, ist.

4. Leseverstärkeranordnung nach einem der Ansprüche 1 bis 3,
**dadurch gekennzeichnet, dass**
im abgeschalteten Zustand des Feldeffekttransistors das Wannenpotential den Wert 0 V hat.

5. Leseverstärkeranordnung nach einem der Ansprüche 1 bis 4,
**dadurch gekennzeichnet, dass**
mehrere Feldeffekttransistoren des Leseverstärkers in ein und derselben Wanne liegen.

## Claims

1. Sense amplifier arrangement having a field-effect transistor provided in a semiconductor substrate, having a short channel length (L_{Design}) and an adjustable threshold voltage (Vth), in which the field-effect transistor (10) is provided in a well (9), which well is insulated in the semiconductor substrate (4, 5) and has a terminal (B) at which a variable well potential (V_{BS}) is present,
**characterized in that**
the well potential (V_{BS}) can be controlled as a function of the difference between the actual threshold voltage (Vth) of the field-effect transistor (10) and the target value thereof.

2. Sense amplifier arrangement according to Claim 1,
**characterized in that**
the threshold voltage (Vth) of the field-effect transistor (10) increases with increasing negative voltage values of the well potential (V_{BS}).

3. Sense amplifier arrangement according to Claims 1 or 2,
**characterized in that**
the well potential is variable between +200 mV and -400 mV in steps of approximately 50 mV.

4. Sense amplifier arrangement according to one of Claims 1 to 3,
**characterized in that**
in the switched-off state of the field-effect transistor, the well potential has the value 0 V.

5. Sense amplifier according to one of Claims 1 to 4,
**characterized in that**
a plurality of field-effect transistors of the sense amplifier are located in one and the same well.

## Revendications

1. Amplificateur de lecture comprenant un transistor à effet de champ prévu dans un substrat semiconducteur, ayant une petite longueur (L_{design}) de canal et une tension (Vth) de coupure réglable, dans lequel le transistor (10) à effet de champ est prévu dans un caisson (9) isolé dans le substrat (4,5) semiconducteur et ayant une borne (B) à laquelle s'applique un potentiel (V_{Bs}) de caisson variable,
**caractérisé en ce que**
le potentiel (V_{BS}) de caisson peut être commandé en fonction de la différence entre la tension (Vth) de coupure réelle du transistor (10) à effet de champ et sa valeur visée.

2. Amplificateur de lecture selon la revendication 1,
**caractérisé en ce que**
la tension (Vth) de coupure du transistor (10) à effet de champ augmente au fur et à mesure que les valeurs de tension négatives du potentiel (V_{BS}) de caisson deviennent plus grandes.

3. Amplificateur de lecture selon la revendication 1ou 2,
**caractérisé en ce que**
le potentiel de caisson est variable entre + 200 mV et - 400 mV par palier d'environ 50 mV.

4. Amplificateur de lecture selon l'une des revendications 1 à 3,
**caractérisé en ce que**
à l'état non passant du transistor à effet de champ, le potentiel de caisson a la valeur 0 V.

5. Amplificateur de lecture selon l'une des revendications 1 à 4,
**caractérisé en ce que**
plusieurs transistors à effet de champ de l'amplificateur se trouvent dans un seul et même caisson.
